# EUROPEAN PATENT APPLICATION

(11) **EP 4 606 246 A1**
(43) Date of publication of application: **27.08.2025**
(21) Application number: 22962721.1
(22) Date of filing: 19.10.2022
(51) Int. Cl.: A24F 40/65

(54) **COVER**

(71) Applicant: Japan Tobacco Inc., Tokyo 105-6927 (JP)
(72) Inventor: FUJIKI, Takashi, Tokyo 130-8603 (JP); YOSHIDA, Ryo, Tokyo 130-8603 (JP)
(74) Representative: Hoffmann Eitle
(86) International application number: PCT/JP2022/038864
(87) International publication number: WO 2024/084609

(57) **Abstract**

A cover attached to a main body having a heating unit for heating a substrate that contains an aerosol source, the cover comprising: a notification unit 104 for displaying information; a communication unit for receiving electromagnetic waves sent from a beacon transmitter 40 for sending the electromagnetic waves; and a control unit for causing the notification unit 104 to display information contained in the electromagnetic waves received by the communication unit.

## Description

### [Technical Field]

The present disclosure relates to a cover.

### [Background Art]

It has been proposed to display information relating to device operation, etc. on a casing or the like of an inhalation device which generates an aerosol serving as an inhalation component and provides the aerosol for inhalation by a user. The inhalation device described in PTL 1 comprises a panel which is detachable from a housing of a main body. The main body has a display window which is an opening aligned with an LED disposed inside the main body and allows light from the LED to pass through to a display unit on the panel. This enables a user to see the light from an outside surface of the panel. Using predetermined modes of light emission, the LED notifies information relating to operation of the inhalation device, such as a state in which a power source of the inhalation device is ON, a state of progress of preheating, and a remaining time for which inhalation is possible, for example.

### [Citation List]

### [Patent Literature]

[PTL 1] WO 2022/079896 A1

### [Summary of Invention]

### [Technical Problem]

From the point of view of user convenience, it would be desirable to display information other than information relating to operation of the inhalation device on a member configured to be detachable from the device main body of the inhalation device.

The objective of the present disclosure lies in providing a cover capable of displaying information other than information relating to operation of an inhalation device.

### [Solution to Problem]

One aspect of the present disclosure provides a cover attached to a main body having a heating unit for heating a substrate that contains an aerosol source, the cover comprising: a display unit for displaying information; a reception unit for receiving electromagnetic waves sent from a transmitter for sending the electromagnetic waves; and a display control unit for causing the display unit to display information contained in the electromagnetic waves received by the reception unit.

In this cover, the reception unit may receive information relating to an advertisement for a sales outlet which was sent from the sales outlet, and the display control unit may cause the display unit to display the advertisement.

In this cover, the reception unit may receive information relating to a coupon usable in a sales outlet which was sent from the sales outlet, and the display control unit may cause the display unit to display the coupon.

In this cover, the reception unit may receive information that a given area is a smoking area, which was sent from the smoking area, and the display control unit may cause the display unit to display the information that the given area is a smoking area.

In this cover, the reception unit may receive location information of the smoking area which was sent from the smoking area, and the display control unit may cause the display unit to display the location information of the smoking area.

In this cover, the reception unit may receive information indicating that smoking articles are for sale, which was sent from a smoking article vending machine, and the display control unit may cause the display unit to display the information indicating that smoking articles are for sale.

In this cover, the reception unit may receive electromagnetic waves sent at fixed intervals by the transmitter, and, when the strength of a signal received by the reception unit is equal to or greater than a predetermined strength, the display control unit may cause the display unit to display information contained in the electromagnetic waves.

In this cover, the reception unit may receive electromagnetic waves sent at fixed intervals by the transmitter, and, when a period in which the strength of a signal received by the reception unit is equal to or greater than a predetermined strength has passed a predetermined period, the display control unit may cause the display unit to display information contained in the electromagnetic waves.

### [Advantageous Effects of Invention]

According to an aspect of the present disclosure, information other than information relating to operation of an inhalation device can be displayed on a member configured to be detachable from a device main body of the inhalation device.

### [Brief Description of Drawings]

[Fig. 1] is a diagram in which a front face side of an aerosol generating device is viewed from diagonally above.
[Fig. 2] is a diagram in which the front face side of the aerosol generating device is viewed from diagonally below.
[Fig. 3] is a diagram in which the aerosol generating device from which a shutter has been removed is viewed from above.
[Fig. 4] is a diagram in which a main body device with a front panel removed is viewed from a front face.
[Fig. 5] is a view of a rear face of the front panel removed from the main body device.
[Fig. 6] is a diagram schematically showing an internal configuration of the aerosol generating device.
[Fig. 7] is a diagram schematically showing connection relationships of a power source system circuit in the front panel and the main body device.
[Fig. 8] is a flowchart illustrating an example of an operation before heating performed by the control unit in the main body device of the aerosol generating device.
[Fig. 9] is a diagram illustrating a situation in which the front panel of the aerosol generating device receives a signal from a beacon transmitter.
[Fig. 10] is a flowchart showing operations of the control unit on the front panel when display information is acquired directly from the beacon transmitter.
[Fig. 11] is a flowchart showing operations of the control unit on the front panel when display information is acquired directly from a server.
[Fig. 12] is a diagram illustrating an example of display of sales outlet-related information on a notification unit of the front panel of the aerosol generating device, where fig. 12(A) shows a situation in which the aerosol generating device receives a radio signal from the beacon transmitter, fig. 12(B) shows one example of display on the notification unit, and fig. 12(C) shows another example of display on the notification unit.
[Fig. 13] is a diagram illustrating an example of display of smoking area-related information on the notification unit of the front panel of the aerosol generating device, where fig. 13(A) shows a situation in which the aerosol generating device receives a radio signal from the beacon transmitter, and fig. 13(B) shows one example of display on the notification unit.
[Fig. 14] shows another example of display of smoking area-related information on the notification unit of the front panel of the aerosol generating device.
[Fig. 15] is a diagram illustrating an example of display of smoking article vending machine-related information on the notification unit of the front panel of the aerosol generating device, where fig. 15(A) shows a situation in which the aerosol generating device receives a radio signal from the beacon transmitter, and fig. 15(B) shows one example of display on the notification unit.
[Fig. 16] shows another example of display of smoking article vending machine-related information on the notification unit of the front panel of the aerosol generating device.
[Fig. 17] is a flowchart showing operations of the control unit on the front panel when display information is acquired directly from a server via a relay device.

### [Description of Embodiments]

Embodiments of the present disclosure will be described in detail below with reference to the appended drawings. An aerosol generating device according to the embodiments is a form of electronic cigarette. A substance generated by the aerosol generating device is an aerosol. An aerosol is a mixture of minute liquid or solid particles suspended in a gas, and air or another gas. The embodiments describe aerosol generating devices which generate the aerosol without associated burning. Furthermore, the embodiments describe aerosol generating devices to which a solid aerosol source can be fitted.

### <Device Configuration>

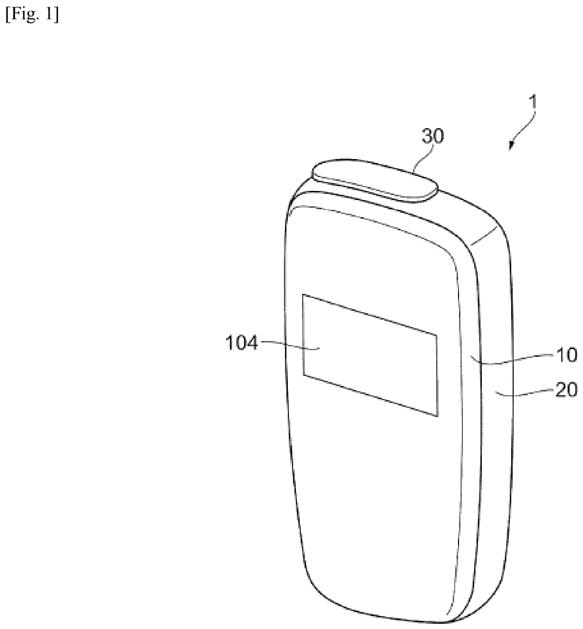

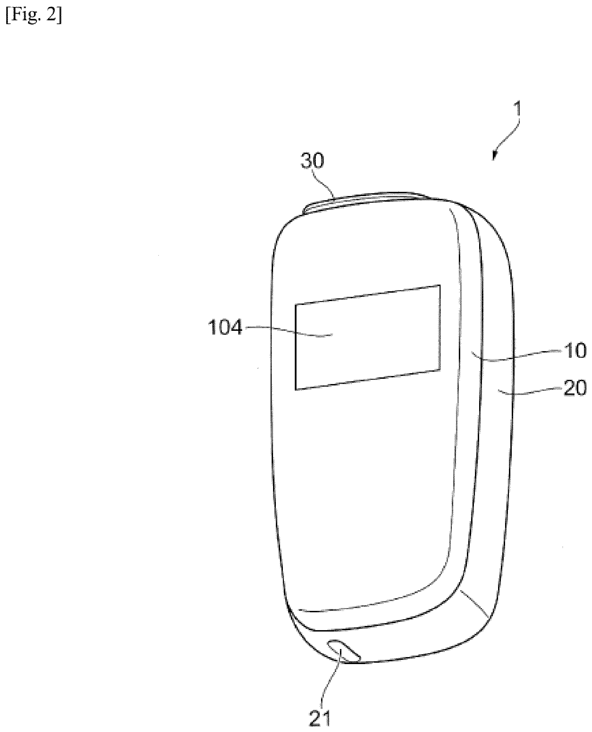

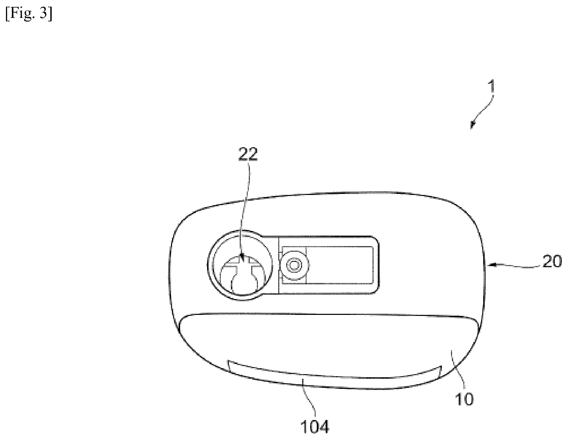

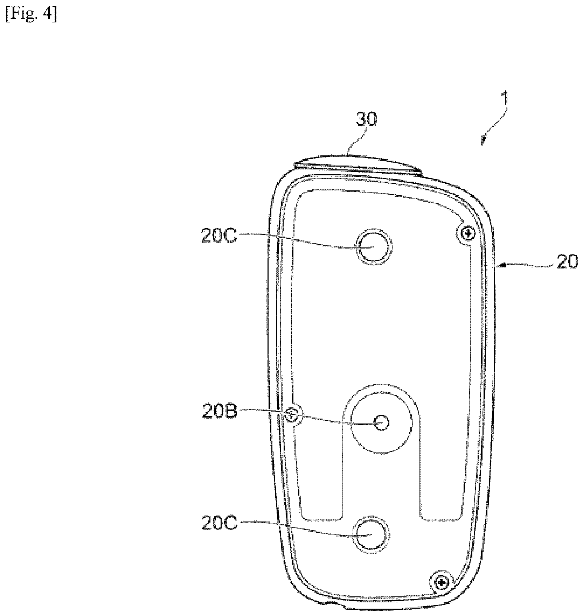

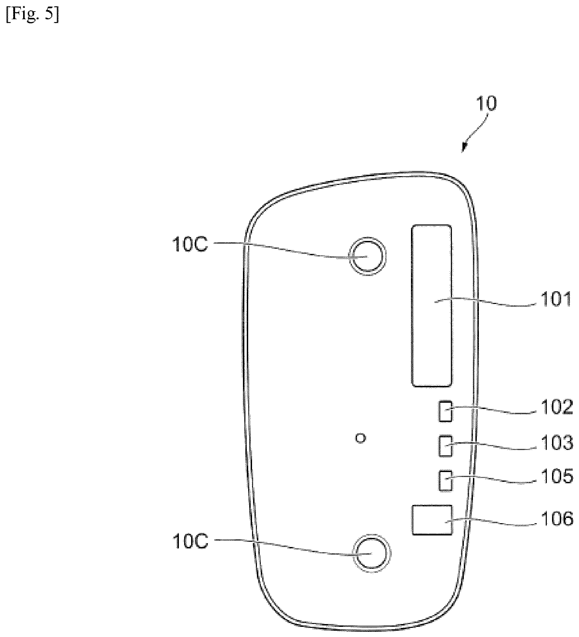

Fig. 1 is a diagram in which a front face side of an aerosol generating device is viewed from diagonally above. Fig. 2 is a diagram in which the front face side of the aerosol generating device is viewed from diagonally below. Fig. 3 is a diagram in which the aerosol generating device from which a shutter has been removed is viewed from above. Fig. 4 is a diagram in which a main body device with a front panel removed is viewed from a front face. Fig. 5 is a view of a rear face of the front panel removed from the main body device.

An aerosol generating device 1 has a size such that a user can hold it in one hand. The aerosol generating device 1 comprises: a main body device 20; a front panel 10 attached to a front face of the main body device 20; and a shutter 30 which is disposed on an upper face of the main body device 20 and can be slidably operated along the upper face. The front panel 10 is a member which is detachable from the main body device 20.

The front panel 10 attached to the main body device 20 covers a front face part of the main body device 20, as shown in fig. 1 and 2. In other words, parts of the main body device 20 other than the front face part are not covered by the front panel 10 even after the front panel 10 has been attached. A state is therefore maintained in which side faces, a back face, an upper face, and a bottom face of the main body device 20 are still visible from the outside after attachment of the front panel 10. The front panel 10 attached to the main body device 20 joins continuously and steplessly with the side faces, upper face and bottom face of the main body device 20, as shown in fig. 1 and 2, forming an integral external appearance.

The front panel 10 is an example of a cover. In a state in which the front panel 10 is attached to the main body device 20, the front panel 10 has the external appearance of being continuously joined to the main body device 20, as described above, and thus has a decorative role. Furthermore, the front panel 10 also has the role of alleviating propagation of heat released from the main body device 20, etc. In addition, the front panel 10 has the role of protecting the main body device 20 from soiling and scratches, etc.

A power source unit 101 capable of charging/discharging electricity; a charging circuit 102 for charging the power source unit 101 using power supplied from the main body device 20; and an electrical supply circuit 103 for supplying the main body device 20 with power stored in the power source unit 101 are attached to an inner side of the front panel 10. A film-type lithium ion secondary battery or a capacitor, for example, is used for the power source unit 101. It should be noted that the arrangement of the power source unit 101, the charging circuit 102, and the electrical supply circuit 103 in fig. 5 is merely an example, and the arrangement is not limited to that depicted. Furthermore, a plurality of power source units 101 may be fitted to the front panel 10. A notification unit 104 may further be provided on an outer side of the front panel 10, as shown in fig. 1 and 2. It should be noted that the arrangement of the notification unit 104 shown in fig. 1 and 2 is merely an example, and the arrangement is not limited to that depicted.

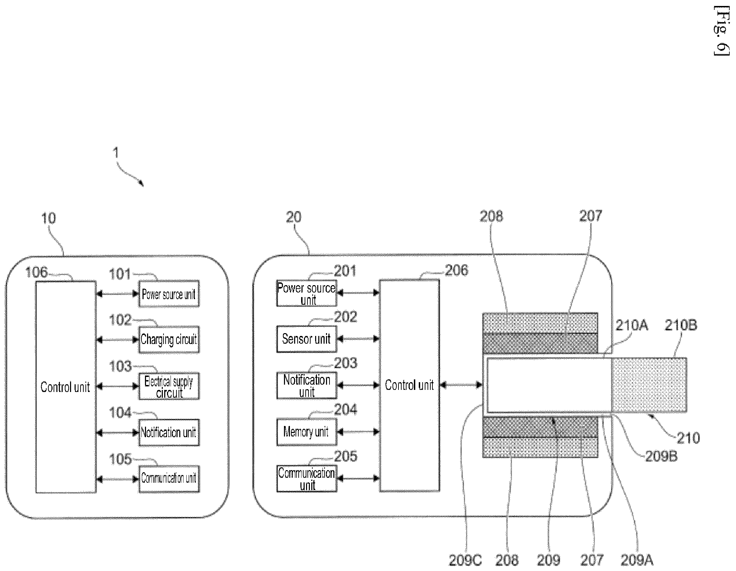

A connector 21 for charging a power source unit 201 (see fig. 6) built into the main body device 20 is provided on the bottom face side of the main body device 20. There is no particular limitation as to the form of the connector 21, and a Type-C USB (= universal serial bus) connector may be used, to give one example.

A hole 22 for insertion of a stick-type substrate 210 (see fig. 6) accommodating an aerosol source is provided in an upper face portion of the main body device 20. The stick-type substrate 210 used in the embodiment accommodates a solid aerosol source in a paper tube molded substantially into a cylindrical shape. The hole 22 is exposed by sliding the shutter 30 to an open position, and hidden by sliding the shutter 30 to a closed position. The hole 22 has a cylindrical shape virtually the same as that of the stick-type substrate 210. The diameter of an opening part of the hole 22 constitutes the dimension of a stick-type substrate 210 of cylindrical cross section which can be inserted.

A magnet, for example, is attached to a rear face of the shutter 30. Meanwhile, a Hall IC is attached to the main body device 20 in a movable range of the shutter 30. The Hall IC is a magnetic sensor formed by a Hall element and an operational amplifier, etc., and outputs a voltage commensurate with the intensity of the magnetic field passing across the Hall element. The shutter 30 being in an open position or a closed position is detected from a change in the voltage output from the Hall IC accompanying sliding of the shutter 30.

A button 20B is disposed substantially in the center of the front face of the main body device 20. When a position on the front panel 10 corresponding to the button 20B is pushed in while the front panel 10 is attached to the main body device 20, the front panel 10 deforms and the button 20B is pressed. As a result, the button 20B is operable while the front panel 10 remains in an attached state. The button 20B is used, for example, for turning the power source of the main body device on and off, for turning the power supply to a heating unit 207 (see fig. 6) for heating the aerosol source on and off, and for Bluetooth (registered trademark) pairing commands, etc. Moreover, a reset function is performed by a long press (e.g., pressing for 5 seconds or more) of the button 20B while the front panel 10 is removed from the main body device 20. BLE (= Bluetooth low energy) is used as Bluetooth, for example.

Magnets 20C used for attaching the front panel 10 are disposed on the upper portion and lower portion of the front face of the main body device 20. The magnets 20C are provided at positions facing magnets 10C provided on the inner side of the front panel 10. The magnets 20C on the main body device 20 and the magnets 10C on the front panel 10 have attracting polarities. When the magnets 10C on the front panel 10 are N poles, the magnets 20C on the main body device 20 side are S poles, for example. The front panel 10 is detachably attached to the main body device 20 by the force of attraction of the magnets. It should be noted that either the magnets 10C or the magnets 20C may be metal pieces made of iron or another magnetic metal. Attachment of the front panel 10 to the main body device 20 is detected by means of the Hall IC provided on the main body device 20 side.

Various other types of electronic components required for generating an aerosol are built into the main body device 20. In this sense, the main body device 20 is an example of an electronic device specifically for generating an aerosol. Moreover, in a narrow sense the main body device 20 is referred to as an aerosol generating device.

### <Internal Configuration>

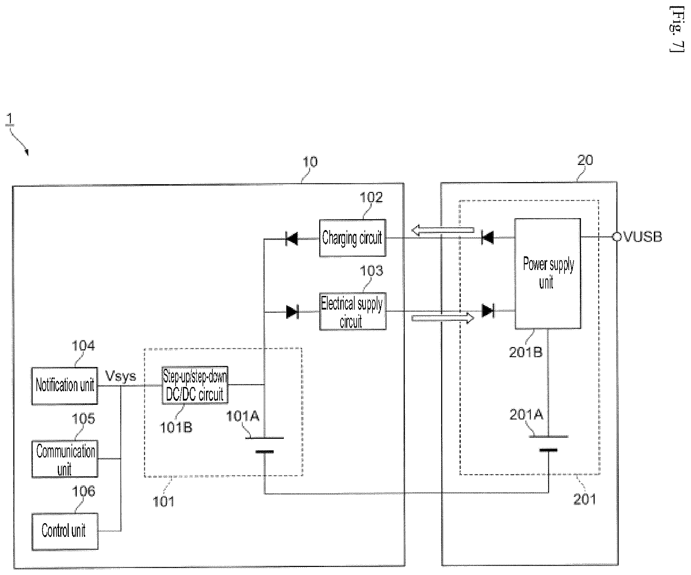

Fig. 6 is a diagram schematically showing an internal configuration of the aerosol generating device 1. Fig. 7 is a diagram schematically showing connection relationships of a power source system circuit in the front panel 10 and the main body device 20. It should be noted that fig. 6 shows a state in which the stick-type substrate 210 is fitted to the main body device 20. Furthermore, the internal configuration shown in fig. 6 is intended to illustrate the components provided in the front panel 10 and the main body device 20 and positional relationships thereof. For this reason, the external appearance of the components, etc. shown in fig. 6 does not always match the external appearance diagrams described above.

The front panel 10 is provided with: the power source unit 101 for storing electricity; the charging circuit 102 for charging the power source unit 101 using power supplied from the main body device 20 side; the electrical supply circuit 103 for supplying the main body device 20, etc. with power from the power source unit 101; the notification unit 104 for notifying information; a communication unit 105; and a control unit 106.

The power source unit 101 is realized by means of a secondary battery 101A and is further provided with a step-up/step-down DC/DC circuit 101B. A lithium ion secondary battery is used as the secondary battery 101A, for example. In the power source unit 101, the step-up/step-down DC/DC circuit 101B generates a 3.3 V power source Vsys from an output voltage of the secondary battery 101A, and supplies this to the notification unit 104, the communication unit 105, and the control unit 106.

The charging circuit 102 is configured by a step-up DC/DC circuit, for example. The charging circuit 102 is a circuit for supplying a voltage of 4.2 V, for example, to the secondary battery 101A when the charging circuit 102 is supplied with power from the main body device 20. Moreover, the charging circuit 102 is provided with a circuit for preventing a reverse current.

The electrical supply circuit 103 is configured by a step-up DC/DC circuit, for example. The electrical supply circuit 103 is a circuit for supplying a constant voltage (e.g., 5 V) to the main body device 20, regardless of the output voltage of the power source unit 101. Moreover, the electrical supply circuit 103 is provided with a circuit for preventing a reverse current.

Power supply from the main body device 20 to the charging circuit 102 and power supply from the electrical supply circuit 103 to the main body device 20 may be either contact power supply or contactless power supply. Examples of contact power supply methods which may be used include a method using the mechanical contact of electrodes, a method using the mechanical contact of spring-loaded electrode pins (pogo pins), and a method using connector coupling. Contactless power supply may employ power supply based on electromagnetic induction systems, such as the Qi standard and the NFC (= near field communication) standard, and power supply based on electric field induction systems.

The notification unit 104 is a display device for notifying various types of information by displaying text or images. The notification unit 104 is realized, for example, by means of a liquid crystal display, an organic EL (= electroluminescence) display, a micro LED (= light-emitting diode), or other display device. The notification unit 104 displays information such as residual power in the built-in secondary battery, current operating mode of the main body device 20 (large-amount-of-aerosol generating mode, small-amount-of-aerosol generating mode), an aerosol inhalation history, time of day, and error information, for example. Furthermore, the notification unit 104 displays various types of information acquired by communication with another external device, for example. Note that the notification unit 104 is an example of a display unit.

The communication unit 105 is a communication interface for performing communication between the main body device 20 and another device. The communication unit 105 acquires status information from the main body device 20 and sends this status information to the notification unit 104. Furthermore, the communication unit 105 connects with other devices by means of control performed by the control unit 106, and acquires information to send to the notification unit 104. The communication unit 105 communicates with other devices by means of a system based on any wired or wireless communication standard. Examples of communication standards include wireless LAN (= local area network), serial signal line, Wi-Fi (registered trademark), and Bluetooth, etc.

The communication unit 105 receives signals sent from a beacon transmitter employing radio waves. The beacon transmitter is provided, for example, in a facility such as a sales outlet or a smoking area, or a vending machine selling tobacco articles such as cigarettes. When a user in possession of the aerosol generating device 1 approaches a facility in which a beacon transmitter is provided and enters a region where radio waves of the beacon transmitter can be received, the communication unit 105 receives the radio waves sent from the beacon transmitter. By this means, the control unit 106 acquires information relating to the facility in which the beacon transmitter is provided. Note that the communication unit 105 is an example of a reception unit.

The control unit 106 is a device for performing various types of arithmetic processing and control in relation to the front panel 10 by reading and executing programs. The control unit 106 is realized by means of an electronic circuit such as a central processing unit (= CPU), a microprocessing unit (= MPU), a graphical processing unit (= GPU), an application-specific integrated circuit (= ASIC), a field programmable gate array (= FPGA), or a digital signal processor (= DSP). The control unit 106 may also include a read only memory (= ROM) for storing programs and computation parameters, etc., and a random access memory (= RAM) for temporarily storing suitably changing parameters, etc.

The control unit 106 controls, for example: communication with the main body device 20, communication with another device such as a smartphone, display provided by the notification unit 104, charging of the secondary battery 101A of the power source unit 101 by means of the charging circuit 102 and the electrical supply circuit 103, and power supply to electronic components, etc. The control unit 106 additionally performs processing, etc. based on input of information to the electronic components on the front panel 10 and information output from the electronic components. The control unit 106 additionally causes the notification unit 104 to display information acquired on the basis of radio waves received by the communication unit 105 from the beacon transmitter. The control unit 106 is an example of a display control unit. Charging from a USB cable is feasible for charging of the secondary battery 101A. Charging from the secondary battery 201A in the main body device 20 could also be possible.

For control in the front panel 10, internal communication between the control unit 106 and the various units employs, for example, a serial communication method such as an inter-integrated circuit (= I2C) communication method, a serial peripheral interface (= SPI) communication method, or a universal asynchronous receiver transmitter (= UART) communication method. An SPI communication method or a UART communication method is used for communication between the control unit 106 and the main body device 20.

The main body device 20 is provided with: a power source unit 201, a sensor unit 202, a notification unit 203, a memory unit 204, a communication unit 205, a control unit 206, a heating unit 207, a heat insulating portion 208, and a holding portion 209. Fig. 6 shows a state in which the stick-type substrate 210 is held in the holding portion 209, and the user inhales the aerosol in this state.

The power source unit 201 is a unit for supplying power to the front panel 10 and the main body device 20. The power source unit 201 stores power using a lithium-ion secondary battery or a capacitor, for example. The example shown in fig. 7 is configured so that power is stored in the secondary battery 201A. The secondary battery 201A is chargeable from an external power source. A mains power source, a mobile battery, and the secondary battery 101A on the front panel 10, etc. may be used as the external power source, for example.

Furthermore, the power source unit 201 is provided with a power supply unit 201B. The power supply unit 201B switches the supply path of power and converts voltage levels, depending on the operation mode. The power supply unit 201B outputs e.g., 3.3 V to the power source line to which are connected the sensor unit 202, the notification unit 203, the memory unit 204, the communication unit 205, and the control unit 206 (see fig. 30). Furthermore, the power supply unit 201B outputs e.g., 4.2 V to the power source line to which the heating unit 207 is connected. When the secondary battery 201A is charged by an external power source, the power supply unit 201B outputs e.g., 4.2 V to the power source line to which the secondary battery 201A is connected. A USB cable is used for supplying electricity from a mains power source or a mobile battery serving as an external power source. An electrical supply terminal corresponding to these external power sources is denoted by "VUSB" in fig. 7.

The sensor unit 202 is an electronic component for detecting various types of information relating to the main body device 20. Sensors constituting the sensor unit 202 include a pressure sensor such as a microphone capacitor, and a flow rate sensor, for example. The sensor unit 202 outputs detected information to the control unit 206. For example, when a change in air pressure or a flow of air accompanying inhalation has been detected, the sensor unit 202 outputs a numerical value representing inhalation by the user to the control unit 206.

The sensor unit 202 has an input device for receiving user input, for example. The input device is realized by means of a button or a switch, for example. The button 20B shown in fig. 4 is an example of an input device. The button 20B is used for switching a main power source on and off, and for switching starting and stopping of electrical supply to the heating unit 207 (in other words, starting and stopping of aerosol generation), etc. The content of user commands is output from the sensor unit 202 to the control unit 206.

The sensor unit 202 additionally has a temperature sensor for detecting the temperature of the heating unit 207. The temperature sensor detects the temperature of the heating unit 207 on the basis of an electrical resistance value of a conductive track of the heating unit 207, for example. The detected electrical resistance value is output from the sensor unit 202 to the control unit 206. It should be noted that the control unit 206 calculates the temperature of the heating unit 207 on the basis of the electrical resistance value. In other words, the control unit 206 calculates the temperature of the stick-type substrate 210 which is held in the holding portion 209.

The notification unit 203 is an electronic component for notifying the user of various types of information relating to the main body device 20. The notification unit 203 may be configured, for example, by a light-emitting device such as an LED (= light-emitting diode), a display device for displaying images, a sound output device for outputting sounds, or a vibration device for causing the main body device 20 to vibrate, etc. The notification unit 203 may also notify the user of a state in which the aerosol can be inhaled. This notification is made when the temperature of the stick-type substrate 210 heated by means of the heating unit 207 has reached a predetermined temperature.

The memory unit 204 stores various types of information relating to operation of the main body device 20. The memory unit 204 is configured by a non-volatile storage medium such as a flash memory, for example. Information stored in the memory unit 204 includes an operating system (= OS) and firmware (= FW), and other programs, for example. Furthermore, the information stored in the memory unit 204 includes information relating to control of electronic components, for example. The information relating to control includes, for example, information relating to inhalation by the user, such as number of inhalations, times of inhalation, and cumulative inhalation time.

The communication unit 205 is a communication interface for implementing communication between the main body device 20 and another device. The communication unit 205 communicates with other devices by means of a system based on any wired or wireless communication standard. Examples of communication standards include wireless LAN, serial signal line, Wi-Fi, and Bluetooth, etc. For example, the communication unit 205 sends the information relating to user inhalation to a smartphone. Furthermore, the communication unit 205 downloads, from a server, update programs and profiles stipulating changes in temperature of the heating unit 207 in a heating mode. Furthermore, the communication unit 205 sends, to the electrical supply circuit 103, commands for starting and stopping power supply.

The control unit 206 functions as an arithmetic processing device and a control device, controlling operations of the main body device 20 in accordance with various programs. Furthermore, the control unit 206 may control operations of the charging circuit 102 and the electrical supply circuit 103 provided on the front panel 10. Control signals are sent through signal lines different from the power source line. For example, communication inside the main body device 20 employs a serial communication method such as an I2C communication method, an SPI communication method, or a UART communication method. An SPI communication method or a UART communication method is used for communication between the control unit 206 and the charging circuit 102 and electrical supply circuit 103 on the front panel 10. It should be noted that BLE is used for a communication line, for example. The control unit 206 is realized by means of an electronic circuit such as a CPU, MPU, GPU, ASIC, FPGA, or DSP, etc., for example. The control unit 206 may also include a ROM for storing programs and computation parameters, etc., and a RAM for temporarily storing parameters, etc.

The control unit 206 executes various types of processing and control by executing programs. Specifically, the control unit 206 implements: supply of electricity from the power source unit 201 to other electronic components; charging of the power source unit 201; detection of information by the sensor unit 202; notification of information by the notification unit 203; storage and reading of information by the memory unit 204; and sending/receiving of information by the communication unit 205, etc. It should be noted that communication by the communication unit 205 also includes communication with the front panel 10. The control unit 206 additionally controls processing, etc. based on input of information to the electronic components and information output from the electronic components.

The holding portion 209 is a substantially cylindrical container. A space inside the holding portion 209 defined by an inner wall and a bottom face of the container will be referred to as an internal space 209A. The internal space 209A is substantially columnar. An opening 209B allowing the internal space 209A to communicate with the exterior is provided in the holding portion 209. The stick-type substrate 210 is inserted into the internal space 209A from the opening 209B. The stick-type substrate 210 is inserted until a tip end thereof touches a bottom portion 209C. The stick-type substrate 210 is only partially accommodated in the internal space 209A. A state in which the stick-type substrate 210 is accommodated in the internal space 209A will be referred to as the stick-type substrate 210 being held in the internal space 209A.

The inner diameter of at least part of the holding portion 209 in an axial direction thereof is formed so as to be smaller than the outer diameter of the stick-type substrate 210. An outer circumferential surface of the stick-type substrate 210 inserted into the internal space 209A is therefore subjected to pressure from the inner wall of the holding portion 209. The stick-type substrate 210 is held in the internal space 209A by means of this pressure. Furthermore, the holding portion 209 also has a function for defining a flow path for air passing through the stick-type substrate 210. An air inflow hole which is an inlet for air into the flow path is disposed in the bottom portion 209C, for example. Moreover, the opening 209B serves as an air outflow hole which is an outlet for the air.

The holding portion 209 holds a portion of the stick-type substrate 210, with the remaining part of the stick-type substrate 210 protruding outside from a casing of the main body device 20. The part which is held in the holding portion 209 will be referred to below as a substrate portion 210A, and the part protruding from the enclosure will be referred to below as a mouthpiece portion 210B. The aerosol source is accommodated in at least the substrate portion 210A. The aerosol source is a substance which is atomized by heating so as to generate an aerosol. Other than shredded tobacco, the aerosol source contains a processed product obtained by molding a tobacco raw material into a granular form, a sheet form or a powder form, or another tobacco-derived substance. In addition, the aerosol source may also contain a non-tobacco-derived substance produced from a plant other than tobacco, such as mint or herb. The aerosol source may contain a flavoring component such as menthol, for example. When the main body device 20 is a medical inhaler, the aerosol source may contain a drug to be inhaled by a patient. It should be noted that the aerosol source is not limited to a solid, and may equally be a polyhydric alcohol such as glycerol or propylene glycol, or may be a liquid such as water, for example.

At least part of the mouthpiece portion 210B is held in the user's mouth during inhalation. When the user inhales with the mouthpiece portion 210B held in the mouth, air flows into the internal space 209A from the air inflow hole. The air which has flowed in reaches the user's mouth after passing through the internal space 209A and the substrate portion 210A. The air reaching the user's mouth contains the aerosol generated by the substrate portion 210A.

The heating unit 207 is formed by a heater or other heat-generating element. The heating unit 207 is formed by any material such as a metal or polyimide. The heating unit 207 is constructed in the form of a film, for example, and fitted to the outer circumferential surface of the holding portion 209. The aerosol source contained in the stick-type substrate 210 is heated and atomized by the heat generated by the heating unit 207. The atomized aerosol source is mixed with air, etc., and an aerosol is generated. In the example shown in fig. 6, it is assumed that the outer circumferential region of the stick-type substrate 210 is initially heated, with the range of heating steadily moving toward the center.

Atomization of the aerosol source therefore starts from the outer circumferential region of the stick-type substrate 210 and steadily moves toward the center. The heating unit 207 generates heat by means of electrical supply from the power source unit 201. Electrical supply to the heating unit 207 is permitted when predetermined user input is detected via the sensor unit 202, for example. The user input as referred to here includes operation of the shutter 30 (see fig. 1) and/or of the button 20B (see fig. 4). However, electricity is supplied to the heating unit 207 on the assumption that the front panel 10 (see fig. 1) is attached to the main body device 20. By attaching the front panel 10, the temperature transmitted to the user's hand can be reduced as compared to when the front panel 10 is not attached.

Inhalation by the user becomes possible when the temperature of the stick-type substrate 210 heated by means of the heating unit 207 reaches a predetermined temperature. Inhalation of the aerosol by the user is detected by means of the flow rate sensor, etc. in the sensor unit 202, and information relating to detected inhalation is saved in the memory unit 204. Electrical supply to the heating unit 207 is stopped when predetermined user input is subsequently detected by the sensor unit 202. It should be noted that it is also possible to adopt a method in which electricity is supplied to the heating unit 207 during a period in which inhalation by the user is detected by the sensor unit 202, and electrical supply to the heating unit 207 is stopped when inhalation by the user is no longer detected by the sensor unit 202.

Furthermore, in the example of fig. 6, the heating unit 207 is disposed outside the stick-type substrate 210, but it is equally possible for the heating unit 207 to be a blade-like metal piece which is inserted into the stick-type substrate 210 for use, or for the heating unit 207 to be a metal piece built into the stick-type substrate 210. When a metal piece acting as the heating unit 207 is built into the stick-type substrate 210, an induction heating coil should be arranged around the holding portion 209.

The heat insulating portion 208 is a member for reducing propagation of heat generated by the heating unit 207 to the surrounding area. The heat insulating portion 208 is therefore disposed so as to cover at least the outer circumferential surface of the heating unit 207. For example, the heat insulating portion 208 is configured by a vacuum insulating material or an aerogel insulating material, etc. A vacuum insulating material is a heat insulating material in which a state of high vacuum is created by wrapping glass wool and silica (silicon powder), etc. in a resin film, for example, so that heat conduction by gas is as close as possible to zero.

### <Operation of Aerosol Generating Device 1 (Operation Before Heating)>

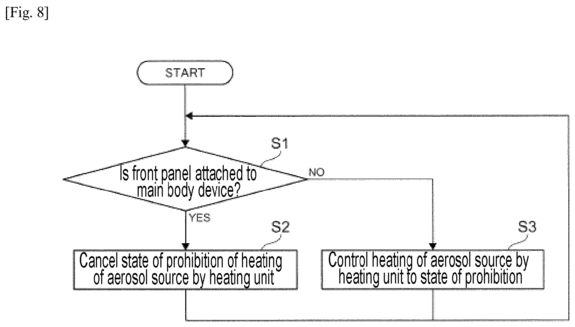

Fig. 8 is a flowchart illustrating an example of an operation before heating performed by the control unit 206 in the main body device 20 of the aerosol generating device 1. The operation before heating is an operation which is implemented before the start of heating by the heating unit 207 (see fig. 6), and is constantly implemented in the background.

The control unit 206 first of all determines whether or not the front panel 10 (see fig. 1) is attached to the main body device 20 (see fig. 1). Attachment/detachment of the front panel 10 is determined on the basis of an output signal from the Hall IC. When the front panel 10 is attached to the main body device 20 (YES in S1), the control unit 206 cancels the state of prohibition of heating of the aerosol source by the heating unit 207 (S2). Meanwhile, in a state in which the front panel 10 is not attached to the main body device 20 (NO in S1), the control unit 206 maintains the state of prohibition of heating of the aerosol source by the heating unit 207 (S3). Heating of the stick-type substrate 210 (see fig. 6) constituting the aerosol source is started by operation of the button 20B (see fig. 4) once the state of prohibition of heating has been canceled as a result of the front panel 10 being attached. The button 20B is operated by a long press of 1 second or greater of the button 20B from above the front panel 10, for example.

### <Operation of Aerosol Generating Device 1 (Display of Information)>

Display of information by the notification unit 104 provided on the front panel 10 of the aerosol generating device 1 will be described below. The communication unit 105 on the front panel 10 receives signals sent from a beacon transmitter disposed in a facility such as a sales outlet or a smoking area (referred to below as a "smoking facility"). The control unit 106 on the front panel 10 displays various types of information on the notification unit 104 based on these signals.

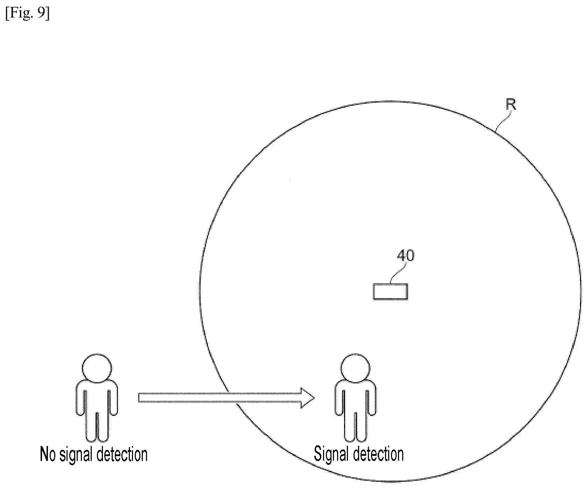

Fig. 9 is a diagram illustrating a situation in which the front panel 10 of the aerosol generating device 1 receives a signal from a beacon transmitter. A beacon transmitter 40 periodically sends signals by means of radio waves such as BLE. In fig. 9, radio wave coverage of the beacon transmitter 40 is denoted by the region R. When a user in possession of the aerosol generating device 1 is outside the region R, the communication unit 105 on the front panel 10 does not receive the radio waves output by the beacon transmitter 40 and no signal is detected (indicated by "no signal detection" in fig. 9). When the user in possession of the aerosol generating device 1 enters the region R, the communication unit 105 on the front panel 10 receives the radio waves of the beacon transmitter 40 and a signal is therefore detected (indicated by "signal detection" in fig. 9).

When the communication unit 105 has received a radio signal stronger than a predetermined first strength, the control unit 106 on the front panel 10 acquires information to be displayed on the notification unit 104 based on the received radio signal. Hereinafter, the first strength of this radio signal is assumed to be a first threshold. Furthermore, when the communication unit 105 has received, continuously for a preset set period, a radio signal which is weaker than the first threshold but stronger than a predetermined second strength, the control unit 106 acquires information to be displayed on the notification unit 104 based on the received radio signal. Hereinafter, the second strength of this radio signal is assumed to be a second threshold. The "set period" which serves as a reference for continuous reception of a radio signal stronger than the second threshold may be freely set, and may be 5 seconds, for example.

The method for acquiring the information displayed on the notification unit 104 (referred to below as "display information") may comprise direct transmission from the beacon transmitter 40 to the front panel 10 of the aerosol generating device 1, or may comprise the front panel 10 of the aerosol generating device 1 acquiring the information by accessing a server using connection information acquired from the beacon transmitter 40. In the case of the former method, for example, data of the display information is stored in a memory means such as a memory built into the beacon transmitter 40 or an external memory device connected to the beacon transmitter 40, and the data of the display information is output from the beacon transmitter 40 together with radio signals.

In the case of the latter method, the display information is held on a server (not depicted) provided separately from the beacon transmitter 40. The server may be arranged in the smoking facility, etc. or may be built on a network as a cloud server or the like. A connection to the server can be made by means of wireless communication using Wi-Fi, etc. The beacon transmitter 40 stores server connection information in the built-in memory and outputs this information together with radio signals. For example, an IP (Internet protocol) address or a URL (uniform resource locator), etc. is used as the server connection information. When the front panel 10 of the aerosol generating device 1 and the server are connected by means of a wireless LAN, a wireless LAN reader may be provided together with the beacon transmitter 40 in the smoking facility, etc.

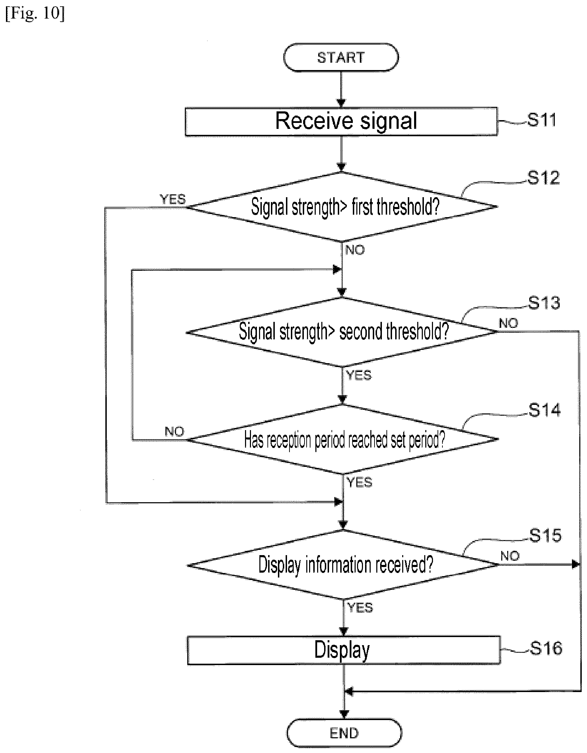

Fig. 10 is a flowchart showing operations of the control unit 106 of the front panel 10 when display information is acquired directly from the beacon transmitter 40. When the user in possession of the aerosol generating device 1 enters the region R (S11) and the communication unit 105 on the front panel 10 receives a radio signal from the beacon transmitter 40, the control unit 106 checks the strength of the received radio signal (indicated by "signal strength" in the drawing). If the signal strength is greater than the first threshold (YES in S12), the control unit 106 determines whether or not display information was received together with the radio signal. When the display information has been received (YES in S15), the control unit 106 displays the display information on the notification unit 104 (S16).

If the signal strength is lower than the first threshold (NO in S12) and greater than the second threshold (YES in S13), the control unit 106 checks a reception period for the radio signal. If the reception period for a radio signal stronger than the second threshold has reached a set period (YES in S14), the control unit 106 determines whether or not display information was received together with the radio signal. When the display information has been received (YES in S15), the control unit 106 displays the display information on the notification unit 104 (S16).

If the signal strength falls below the second threshold before the reception period for the radio signal stronger than the second threshold reaches the set period (NO in S14, NO in S13), the control unit 106 cannot acquire display information and therefore terminates the processing without any display on the notification unit 104. Furthermore, if the signal strength is greater than the first threshold (YES in S12) and if a radio signal stronger than the second threshold is continuously received for the set period (YES in S14) but no display information is present (NO in S15), the control unit 106 cannot acquire display information and therefore terminates the processing without any display on the notification unit 104.

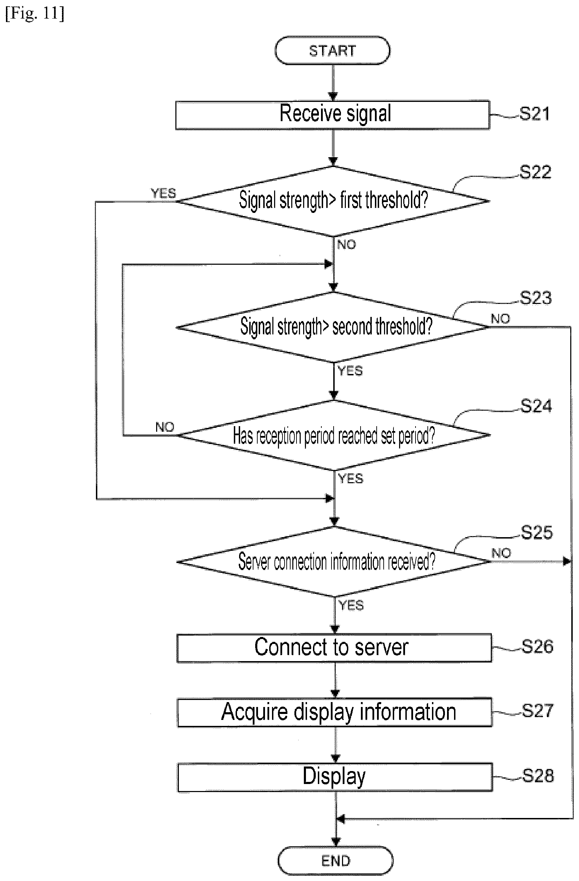

Fig. 11 is a flowchart showing operations of the control unit 106 on the front panel 10 when the display information is acquired directly from a server. The operations of S21-S24 relating to reception of radio signals from the beacon transmitter 40 are the same as the operations of S11-S14 described with reference to fig. 10 and will therefore not be described again.

If the signal strength of a radio signal received from the beacon transmitter 40 is greater than the first threshold (YES in S22), the control unit 106 determines whether or not server connection information was received together with the radio signal. When the connection information has been received (YES in S25), the control unit 106 connects to the server using the received connection information (S26) and acquires the display information (S27). The control unit 106 then displays the acquired display information on the notification unit 104 (S28).

If the signal strength of the radio signal received from the beacon transmitter 40 is lower than the first threshold (NO in S22) and greater than the second threshold (YES in S23), and the reception period for the radio signal stronger than the second threshold has reached the set period (YES in S24), the control unit 106 determines whether or not server connection information was received together with the radio signal. When the connection information has been received (YES in S25), the control unit 106 connects to the server using the received connection information (S26) and acquires the display information (S27). The control unit 106 then displays the acquired display information on the notification unit 104 (S28).

If the signal strength falls below the second threshold before the reception period for the radio signal stronger than the second threshold reaches the set period (NO in S24, NO in S23), the control unit 106 cannot connect to the server to acquire display information and therefore terminates the processing without displaying the display information on the notification unit 104. Furthermore, if the signal strength is greater than the first threshold (YES in S22) and if a radio signal stronger than the second threshold is continuously received for the set period (YES in S24) but no server connection information was received (NO in S25), the control unit 106 cannot connect to the server and therefore terminates the processing without displaying the display information on the notification unit 104.

### <Examples of Display Information>

Several examples of display by the notification unit 104 on the front panel 10 of the aerosol generating device 1 will be described below. It should be noted that, in the examples described below, it makes no difference whether the front panel 10 acquires display information directly from the beacon transmitter 40 or acquires display information from the server because the display information is acquired on the basis of the radio signal received from the beacon transmitter 40, so no distinction will be made.

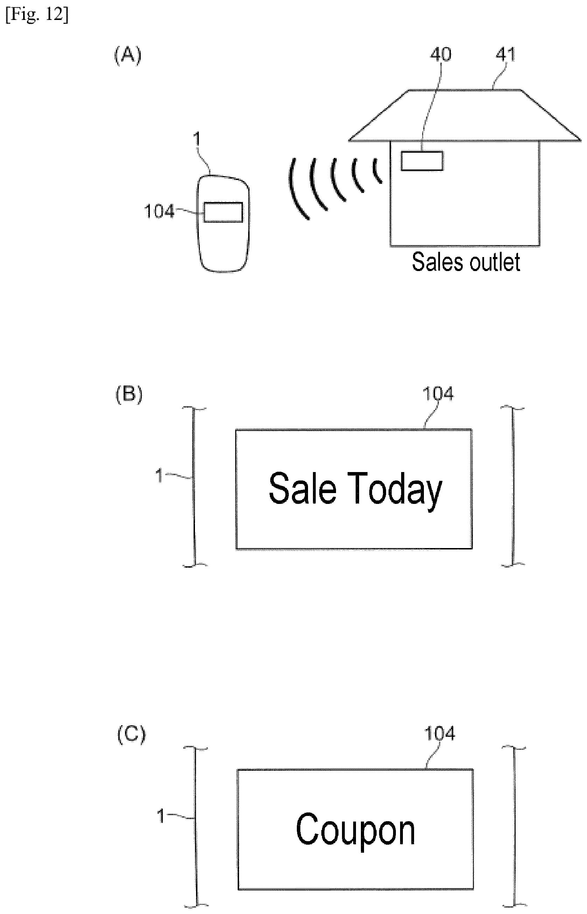

Fig. 12 shows an example of display of sales outlet-related information on the notification unit 104 of the front panel 10 of the aerosol generating device 1. Fig. 12(A) shows a situation in which the aerosol generating device 1 receives a radio signal from the beacon transmitter 40, fig. 12(B) shows one example of display on the notification unit 104, and fig. 12(C) shows another example of display on the notification unit 104.

In the example shown in fig. 12(A), the beacon transmitter 40 is installed in a sales outlet 41. When a user in possession of the aerosol generating device 1 approaches the sales outlet 41 and enters the region R covered by radio waves of the beacon transmitter 40, the aerosol generating device 1 receives a radio signal from the beacon transmitter 40 by means of the communication unit 105 on the front panel 10. The aerosol generating device 1 then acquires the display information on the basis of the received radio signal by means of the control unit 106 on the front panel 10, and displays the acquired display information on the notification unit 104.

In this example, the display information is assumed to be a display of information relating to the sales outlet 41 in which the beacon transmitter 40 is installed. Examples of information relating to the sales outlet 41 that may be cited include an advertisement for the sales outlet 41 or for goods, and a coupon which can be used at the sales outlet 41, etc. In the example shown in fig. 12(B), the aerosol generating device 1 acquires information relating to an advertisement for the sales outlet 41 as the display information, and an advertisement based on the acquired information is displayed on the notification unit 104. Examples of advertisements for the sales outlet 41 which may be displayed include types of goods and services for sale, sales information such as prices, and information including events being held such as a sale. In the example depicted, the text "Sale Today" is displayed as an example of an advertisement.

Furthermore, in the example shown in fig. 12(C), the aerosol generating device 1 acquires information relating to a coupon that can be used at the sales outlet 41 as the display information, and a coupon based on the acquired information is displayed on the notification unit 104. When the user of the aerosol generating device 1 uses the coupon, the user presents the coupon displayed on the notification unit 104 to a shop assistant, etc. when goods are purchased or a service is received at the sales outlet 41.

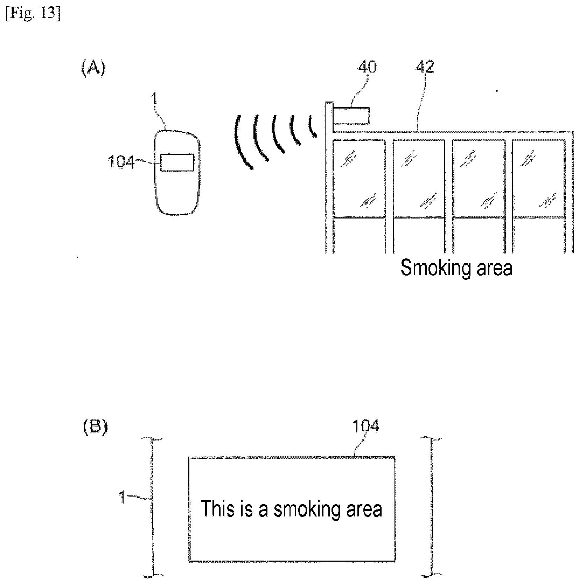

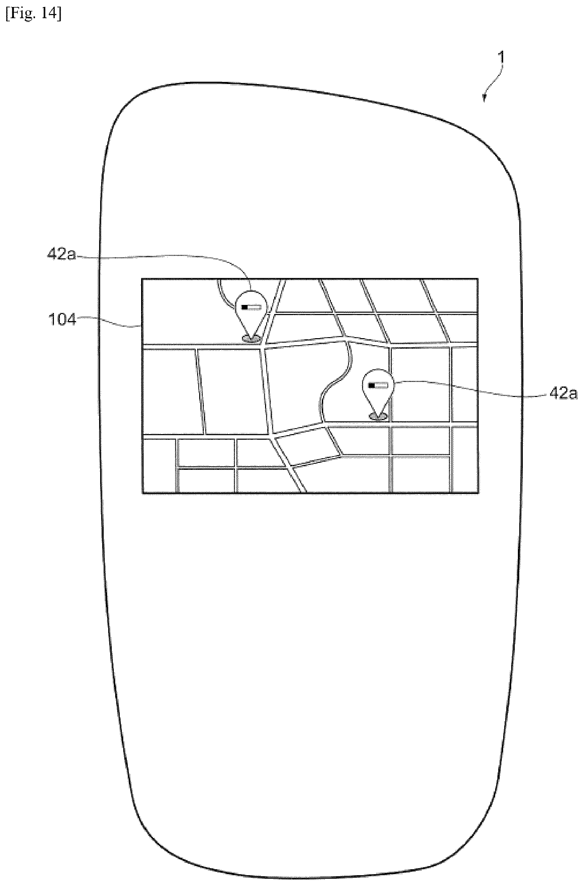

Fig. 13 and 14 show examples of display of smoking area-related information on the notification unit 104 of the front panel 10 of the aerosol generating device 1. Fig. 13(A) shows a situation in which the aerosol generating device 1 receives a radio signal from the beacon transmitter 40, and fig. 13(B) shows one example of display on the notification unit 104. Furthermore, fig. 14 shows another example of display on the notification unit 104.

In the example shown in fig. 13(A), the beacon transmitter 40 is installed in a smoking area 42. When a user in possession of the aerosol generating device 1 approaches the smoking area 42 and enters the region R covered by radio waves of the beacon transmitter 40, the aerosol generating device 1 receives a radio signal from the beacon transmitter 40 by means of the communication unit 105 on the front panel 10. The aerosol generating device 1 then acquires the display information on the basis of the received radio signal by means of the control unit 106 on the front panel 10, and displays the acquired display information on the notification unit 104.

In this example, the display information is assumed to be a display of information relating to the smoking area 42 in which the beacon transmitter 40 is installed. Examples of information relating to the smoking area 42 that may be cited include information indicating that the place where the radio signal of the beacon transmitter 40 was received, in other words the place where the user is present, is a smoking area 42, and information indicating the location of a smoking area 42, etc. In the example shown in fig. 13(B), the aerosol generating device 1 displays information indicating that the place where the user is present is a smoking area 42, as the display information on the notification unit 104. In the example depicted, the text "This is a smoking area" is displayed.

Furthermore, in the example shown in fig. 14, the aerosol generating device 1 acquires information indicating the locations of smoking areas 42 as the display information, and location information of the smoking areas 42 is displayed on the notification unit 104 on the basis of the acquired information. As the information indicating location in the example shown in fig. 14, a map is displayed on the notification unit 104, and marks 42a representing smoking areas 42 are provided at locations on the map corresponding to the smoking areas 42. Two marks 42a are displayed on the map on the notification unit 104 in fig. 14. One of the smoking areas 42 represented by the marks 42a is the smoking area 42 where the beacon transmitter 40 sending the radio signal received by the aerosol generating device 1 is installed, but the other is another smoking area 42. Location information not only for the smoking area 42 corresponding to the received radio signal but also for another smoking area 42 is thus displayed, thereby enabling the user to immediately ascertain the location of another neighboring smoking area 42 if the smoking area 42 which the user was intending to use is crowded.

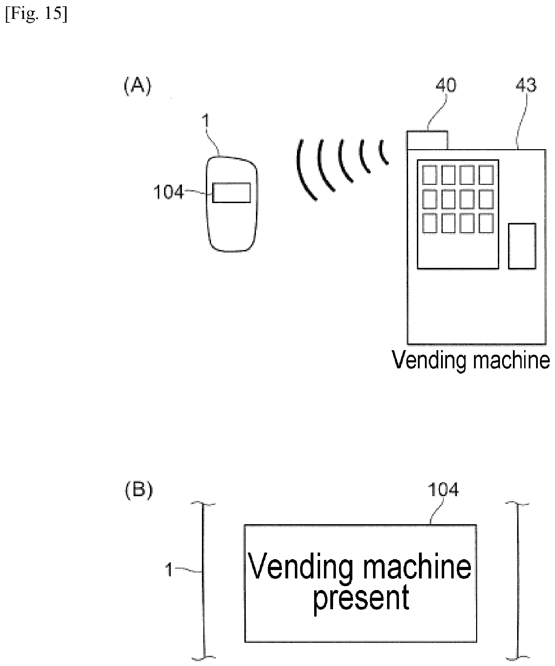

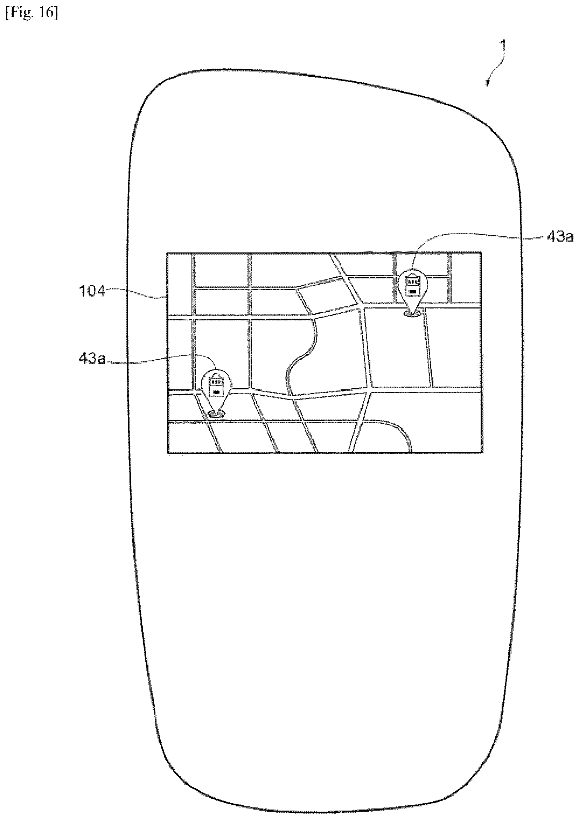

Fig. 15 and 16 show examples of display of smoking article vending machine-related information on the notification unit 104 of the front panel 10 of the aerosol generating device 1. Fig. 15(A) shows a situation in which the aerosol generating device 1 receives a radio signal from the beacon transmitter 40, and fig. 15(B) shows one example of display on the notification unit 104. Furthermore, fig. 16 shows another example of display on the notification unit 104.

In the example shown in fig. 15(A), the beacon transmitter 40 is installed in a vending machine 43. When a user in possession of the aerosol generating device 1 approaches the vending machine 43 and enters the region R covered by radio waves of the beacon transmitter 40, the aerosol generating device 1 receives a radio signal from the beacon transmitter 40 by means of the communication unit 105 on the front panel 10. The aerosol generating device 1 then acquires the display information on the basis of the received radio signal by means of the control unit 106 on the front panel 10, and displays the acquired display information on the notification unit 104.

In this example, the display information is assumed to be a display of information relating to the vending machine 43 in which the beacon transmitter 40 is installed. Examples of information relating to the vending machine 43 that may be cited include information indicating that there is a vending machine 43 at the place where the radio signal of the beacon transmitter 40 was received, in other words information indicating that smoking articles are for sale close to the place where the user is present, and information indicating the location of a vending machine 43, etc. In the example shown in fig. 15(B), the aerosol generating device 1 displays information indicating that there is a vending machine 43 close to the place where the user is present, as the display information on the notification unit 104. In the example depicted, the text "Vending machine present" is displayed.

Furthermore, in the example shown in fig. 16, the aerosol generating device 1 acquires information indicating the locations of vending machines 43 as the display information, and location information of the vending machines 43 is displayed on the notification unit 104 on the basis of the acquired information. As the information indicating location in the example shown in fig. 14, a map is displayed on the notification unit 104, and marks 43a representing vending machines 43 are provided at locations on the map corresponding to the vending machines 43. Two marks 43a are displayed on the map on the notification unit 104 in fig. 16. One of the vending machines 43 represented by the marks 43a is the vending machine 43 where the beacon transmitter 40 sending the radio signal received by the aerosol generating device 1 is installed, but the other is another vending machine 43. Location information not only for the vending machine 43 corresponding to the received radio signal but also for another neighboring vending machine 43 is thus displayed, thereby enabling the user to purchase smoking articles using the desired vending machine 43.

### <Variant Examples>

Embodiments of the present disclosure were described above, but the technical scope of the present disclosure is not limited to the embodiments above. The present disclosure includes various modifications and component substitutions that do not depart from the scope of the technical concept of the present disclosure. Several variant examples will be described below.

In the embodiments above, the display information was acquired from the beacon transmitter 40 or the server, but, depending on display content, it is also possible to adopt a configuration in which the display information is stored in a memory provided in the control unit 106 on the front panel 10 of the aerosol generating device 1, and the display information is read from the memory and displayed on the notification unit 104 on the condition that a radio signal from the beacon transmitter 40 has been received. For example, in the case of the information indicating that a given area is a smoking area shown in fig. 13(B) and the information indicating that a vending machine is present shown in fig. 15(B), the display content does not vary according to the date and time or place, and there is also a small amount of information, so this information can be stored in the memory of the control unit 106.

Furthermore, the embodiments above were described assuming a configuration employing a display device such as a liquid crystal display as the notification unit 104, but information may equally be presented using a light-emitting device such as an LED for displays comprising a small amount of information, as described above. For example, it is possible to adopt a configuration in which the presence of a smoking area nearby and the presence of a smoking article vending machine, etc. are notified by light-emission patterns specific to each by using the LED which notifies the state of charge of the secondary battery built into the aerosol generating device 1.

Furthermore, the embodiments above described an example in which the button 20B provided on the main body device 20 is operated by pressing the front panel 10 fitted to the main body device 20 to cause deformation, but input of instructions to the main body device 20 may also employ a method other than deformation of the front panel 10. For example, a touch panel may be used as the notification unit 104, and information indicating a user operation on the touch panel may be notified to the control unit 206 in the main body device 20 via the communication unit 105. Furthermore, a switch or button may be arranged on the front panel 10, and the presence or absence, etc. of an operation thereon may be notified to the control unit 206 in the main body device 20 via the communication unit 105. The touch panel and switch, etc. as referred to here are examples of an operating unit. Moreover, a heat shielding structure is used on surface members and inside a main body device 20 of this type.

Furthermore, the embodiments above described an example in which aerosol generation is permitted only when the front panel 10 is attached to the main body device 20, but aerosol generation by the main body device 20 may also be possible while the front panel 10 is not attached. In this case, attachment of the front panel 10 to the main body device 20 is used to broaden the functions that may be implemented by the main body device 20. For example, the main body device 20 with the front panel 10 removed operates using only the built-in secondary battery 201A (see fig. 7), and the main body device 20 to which the front panel 10 fitted with the secondary battery is attached enables a function of using power from the secondary battery 101A (see fig. 7) on the front panel 10.

The embodiments above described a case in which display information is acquired directly from the beacon transmitter 40 and a case in which the display information is acquired by accessing a server using connection information acquired from the beacon transmitter 40, as the pathways by which the front panel 10 of the aerosol generating device 1 acquires the display information, but the display information may equally be acquired via another pathway. For example, it is equally possible to adopt a configuration in which the display information is acquired from a server using a portable communication terminal such as a smartphone as a relay device. In this case, the control unit 106 on the front panel 10 pre-registers the relay device as a target communication device. The relay device is registered using Bluetooth pairing or the like, for example, and registration information is stored in the memory of the control unit 106, for example. The control unit 106 connects to the registered relay device by controlling the communication unit 105, and sends server connection information and receives display information from the server.

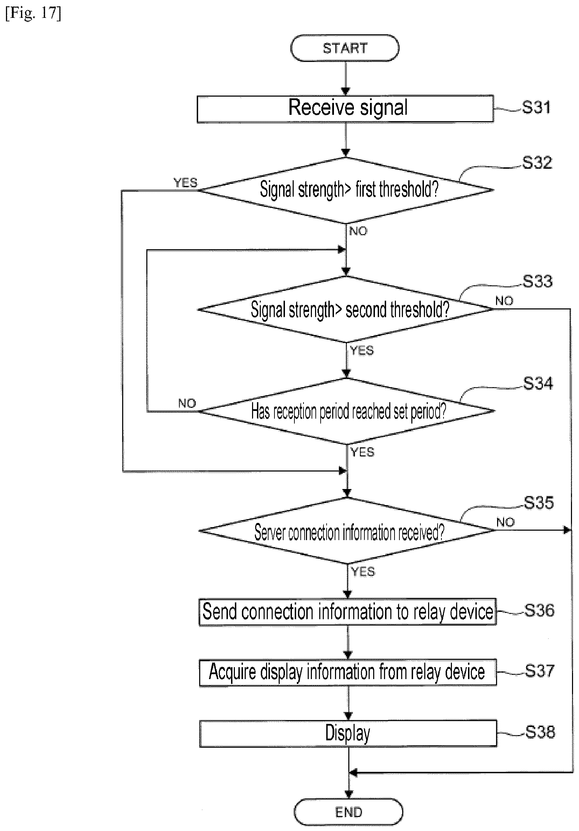

Fig. 17 is a flowchart showing operations of the control unit 106 on the front panel 10 when display information is acquired directly from a server via a relay device. The operations of S31-S34 relating to reception of radio signals from the beacon transmitter 40 are the same as the operations of S11-S14 described with reference to fig. 10 and will therefore not be described again.

If the signal strength of a radio signal received from the beacon transmitter 40 is greater than the first threshold (YES in S32), the control unit 106 determines whether or not server connection information was received together with the radio signal. When the connection information has been received (YES in S35), the control unit 106 sends the received connection information to the registered relay device (S36). The relay device connects to the server using the received connection information and acquires the display information. The relay device then sends the acquired display information to the control unit 106 on the front panel 10. When the control unit 106 acquires the display information from the relay device (S37), the control device 106 displays the acquired display information on the notification unit 104 (S38). If connection information has not been received (NO in S35), display information cannot be acquired by connecting to the server, so the processing is terminated without display information being displayed on the notification unit 104. If the signal strength of the radio signal received from the beacon transmitter 40 is lower than the first threshold (NO in S32) and greater than the second threshold (YES in S33), and the reception period for the radio signal stronger than the second threshold has reached the set period (YES in S34), then the operations of S35 and onward are the same.

In the example above, the front panel 10 of the aerosol generating device 1 received the signal sent from the beacon transmitter 40 and acquired the display information from the server via the relay device such as a smartphone, but the operations up to receiving the signal sent from the beacon transmitter 40 and acquiring the display information from the server may equally be performed by using a portable communication terminal such as a smartphone. The portable communication terminal sends the acquired display information to the control unit 106 on the front panel 10, and the control unit 106 displays the display information received from the portable communication terminal on the notification unit 104. In this case also, the control unit 106 on the front panel 10 pre-registers the portable communication terminal as a target communication device to enable communication with the portable communication terminal.

### <Summary>

It should be noted that the present disclosure includes the following features.
(1) A cover attached to a main body having a heating unit for heating a substrate that contains an aerosol source, the cover comprising: a display unit for displaying information; a reception unit for receiving electromagnetic waves sent from a transmitter for sending the electromagnetic waves; and a display control unit for causing the display unit to display information contained in the electromagnetic waves received by the reception unit.
(2) The cover as disclosed in (1), wherein the reception unit receives information relating to an advertisement for a sales outlet which was sent from the sales outlet, and the display control unit causes the display unit to display the advertisement.
(3) The cover as disclosed in (1) or (2), wherein the reception unit receives information relating to a coupon usable in a sales outlet which was sent from the sales outlet, and the display control unit causes the display unit to display the coupon.
(4) The cover as disclosed in any of (1) to (3), wherein the reception unit receives information that a given area is a smoking area, which was sent from the smoking area, and the display control unit causes the display unit to display the information that the given area is a smoking area.
(5) The cover as disclosed in any of (1) to (4), wherein the reception unit receives location information of the smoking area which was sent from the smoking area, and the display control unit causes the display unit to display the location information of the smoking area.
(6) The cover as disclosed in any of (1) to (5), wherein the reception unit receives information indicating that smoking articles are for sale, which was sent from a smoking article vending machine, and the display control unit causes the display unit to display the information indicating that smoking articles are for sale.
(7) The cover as disclosed in any of (1) to (6), wherein the reception unit receives electromagnetic waves sent at fixed intervals by the transmitter, and, when the strength of a signal received by the reception unit is equal to or greater than a predetermined strength, the display control unit causes the display unit to display information contained in the electromagnetic waves.
(8) The cover as disclosed in any of (1) to (7), wherein the reception unit receives electromagnetic waves sent at fixed intervals by the transmitter, and, when a period in which the strength of a signal received by the reception unit is equal to or greater than a predetermined strength has passed a predetermined period, the display control unit causes the display unit to display information contained in the electromagnetic waves.

### [Reference Signs List]

1... Aerosol generating device; 10... Front panel; 10C, 20C... Magnet; 20... Main body device; 101A, 201A... Secondary battery; 20B... Button; 21... Connector; 22... Hole; 30... Shutter; 40... Beacon transmitter; 101, 201... Power source unit; 101B... Step-up/step-down DC/DC circuit; 102... Charging circuit; 103... Electrical supply circuit; 104... Notification unit; 105... Communication unit; 106... Control unit; 201B... Power supply unit; 202... Sensor unit; 203... Notification unit; 204... Memory unit; 205... Communication unit; 206... Control unit; 207... Heating unit; 208... Heat insulating portion; 209... Holding portion; 210... Stick-type substrate

## Claims

1. A cover attached to a main body having a heating unit for heating a substrate that contains an aerosol source, the cover comprising:
a display unit for displaying information,
a reception unit for receiving electromagnetic waves sent from a transmitter for sending the electromagnetic waves; and
a display control unit for causing the display unit to display information contained in the electromagnetic waves received by the reception unit.

2. The cover as claimed in claim 1, wherein the reception unit receives information relating to an advertisement for a sales outlet which was sent from the sales outlet, and
the display control unit causes the display unit to display the advertisement.

3. The cover as claimed in claim 1 or 2, wherein the reception unit receives information relating to a coupon usable in a sales outlet which was sent from the sales outlet, and
the display control unit causes the display unit to display the coupon.

4. The cover as claimed in any of claims 1 to 3, wherein the reception unit receives information that a given area is a smoking area, which was sent from the smoking area, and
the display control unit causes the display unit to display the information that the given area is a smoking area.

5. The cover as claimed in any of claims 1 to 4, wherein the reception unit receives location information of the smoking area which was sent from the smoking area, and
the display control unit causes the display unit to display the location information of the smoking area.

6. The cover as claimed in any of claims 1 to 5, wherein the reception unit receives information indicating that smoking articles are for sale, which was sent from a smoking article vending machine, and
the display control unit causes the display unit to display the information indicating that smoking articles are for sale.

7. The cover as claimed in any of claims 1 to 6, wherein the reception unit receives electromagnetic waves sent at fixed intervals by the transmitter, and
when the strength of a signal received by the reception unit is equal to or greater than a predetermined strength, the display control unit causes the display unit to display information contained in the electromagnetic waves.

8. The cover as claimed in any of claims 1 to 7, wherein the reception unit receives electromagnetic waves sent at fixed intervals by the transmitter, and
when a period in which the strength of a signal received by the reception unit is equal to or greater than a predetermined strength has passed a predetermined period, the display control unit causes the display unit to display information contained in the electromagnetic waves.
